# EUROPÄISCHE PATENTSCHRIFT

(11) **EP 3 744 033 B1**
(45) Veröffentlichungstag und Bekanntmachung des Hinweises auf die Patenterteilung: **03.08.2022**
(21) Anmeldenummer: 19703780.7
(22) Anmeldetag: 14.01.2019
(51) Int. Cl.: H04L 1/24, H04L 1/22, G05B 9/03

(54) **SYSTEM ZUM ERZEUGEN EINES DATENSTROMS AUF BASIS REDUNDANTER INFORMATIONEN**
SYSTEM FOR PRODUCING A DATA STREAM ON THE BASIS OF REDUNDANT INFORMATION
SYSTÈME DE GÉNÉRATION D'UN FLUX DE DONNÉES EN FONCTION D'INFORMATIONS REDONDANTES

(30) Priorität: 24.01.2018 DE 102018000559
(43) Veröffentlichungstag der Anmeldung: 02.12.2020
(73) Patentinhaber: WAGO Verwaltungsgesellschaft mbH, 32423 Minden (DE)
(72) Erfinder: WEIDNER, Markus, 32429 Minden (DE)
(74) Vertreter: Koplin, Moritz
(86) Internationale Anmeldenummer: PCT/IB2019/000006
(87) Internationale Veröffentlichungsnummer: WO 2019/145778

(56) Entgegenhaltungen:
- EP-A2- 2 256 565
- DE-A1- 10 065 907
- JP-A- H05 292 105

## Beschreibung

### GEBIET

Die vorliegende Erfindung bezieht sich auf ein System zum Erzeugen eines Datenstroms auf Basis redundanter Informationen.

### HINTERGRUND

Ein System gemäß dem Oberbegriff des Anspruchs 1 ist aus der EP 2 256 565 A2 bekannt. Aus dem Stand der Technik sind zudem Systeme bekannt, in denen sicherheitsrelevante Informationen über unsichere Übertragungswege übertragen und empfängerseitig auf Fehler überprüft werden. Dabei können sender- und/oder empfängerseitig redundante Kommunikationseinrichtungen vorgesehen sein, die sich gegenseitig überwachen, indem bspw. Berechnungsergebnisse zyklisch ausgetauscht und verglichen werden.

### ZUSAMMENFASSUNG

Die Erfindung bereichert diesbezüglich den Stand der Technik, als erfindungsgemäße Kommunikationseinrichtungen sicherheitsrelevante Informationen über einen gemeinsamen Übertragungsweg im Wechsel übertragen und den Übertragungsweg während der Übertragung überwachen, wobei sich die Daten beider Kommunikationseinrichtungen gegenseitig so ergänzen, dass eine valide Kommunikation nur stattfinden kann, wenn beide Kommunikationseinrichtungen an der Übertragung mitwirken, und die Kommunikation von beiden Kommunikationseinrichtungen gestoppt werden kann, indem sie ihre Mitwirkung an der Übertragung einstellt.

Ein erfindungsgemäßes System zum Erzeugen eines Datenstroms auf Basis redundanter Informationen nach Anspruch 1 umfasst einen ersten Controller, welcher einen ersten Datenausgang aufweist, wobei der erste Controller eingerichtet ist, einen ersten Teil erster Daten über den ersten Datenausgang auszugeben, einen zweiten Controller, welcher einen zweiten Datenausgang aufweist, wobei der zweite Controller eingerichtet ist, einen zweiten Teil zweiter Daten über den zweiten Datenausgang auszugeben, und eine erste Schaltung, welche mit dem ersten Datenausgang und dem zweiten Datenausgang verbunden ist. Die erste Schaltung ist eingerichtet, die über den ersten und den zweiten Datenausgang ausgegeben Daten zu einem Datenstrom zusammenzusetzen. Der erste Controller ist eingerichtet, zumindest den zweiten Teil zweiter Daten des zusammengesetzten Datenstroms einzulesen. Der zweite Controller ist eingerichtet, zumindest den ersten Teil erster Daten des zusammengesetzten Datenstroms einzulesen. Der erste Controller ist eingerichtet, den eingelesenen zweiten Teil zweiter Daten mit einem zweiten Teil der ersten Daten zu vergleichen und, wenn der Vergleich eine Abweichung ergibt, eine Ausgabe von Daten über den ersten Datenausgang einzustellen und/ oder die Weiterleitung des Datenstroms zu blockieren. Der zweite Controller ist eingerichtet, den eingelesenen ersten Teil erster Daten mit einem ersten Teil der zweiten Daten zu vergleichen und, wenn der Vergleich eine Abweichung ergibt, eine Ausgabe von Daten über den zweiten Datenausgang einzustellen und/oder die Weiterleitung des Datenstroms zu blockieren.

Dabei ist unter dem Begriff "Controller", wie er in der Beschreibung und den Ansprüchen verwendet wird, insbesondere eine elektronische Schaltung zu verstehen, die eingerichtet ist, analoge und/oder digitale Signale im Takt eines Taktsignals einzulesen, zu verarbeiten bzw. auszugeben. Ferner ist unter dem Begriff "Datenausgang", wie er in der Beschreibung und den Ansprüchen verwendet wird, insbesondere ein elektrischer Anschluss zu verstehen, an dem vordefinierte Spannungspegel ausgegeben werden können, wobei eine Folge an Spannungspegeln die auszugebenden Daten repräsentiert. Des Weiteren ist unter dem Begriff "Schaltung", wie er in der Beschreibung und den Ansprüchen verwendet wird, insbesondere ein Zusammenschluss von elektrischen und/ oder elektronischen Bauteilen zu einer funktionsgerechten Anordnung zu verstehen. Zudem ist unter dem Begriff "Datenstrom", wie er in der Beschreibung und den Ansprüchen verwendet wird, insbesondere eine kontinuierliche Abfolge an vordefinierten Spannungspegeln zu verstehen, welche die Daten repräsentieren.

Vorzugsweise weisen die ersten Daten und die zweiten Daten die redundanten Informationen auf.

Dabei sind unter dem Begriff "redundante Informationen", wie er in der Beschreibung und den Ansprüchen verwendet wird, insbesondere Informationen zu verstehen, die (eindeutig) aufeinander abbildbar sind.

Vorzugsweise weist, wenn die Vergleiche keine Abweichungen ergeben, der Datenstrom den zweiten Teil erster Daten und den ersten Teil zweiter Daten auf.

Vorzugsweise stimmen, wenn die Vergleiche keine Abweichungen ergeben, die ersten Daten mit den zweiten Daten überein.

Vorzugsweise sind die Controller derart synchronisiert, dass der erste Teil erster Daten und der zweite Teil zweiter Daten nicht gleichzeitig ausgegeben werden.

Vorzugsweise ist der zweite Controller eingerichtet, sich mittels Einlesens des Datenstroms mit dem ersten Controller zu synchronisieren und den zweiten Teil zweiter Daten über den zweiten Datenausgang auszugeben, nachdem der erste Controller den ersten Teil erster Daten über den ersten Datenausgang ausgegeben hat.

Vorzugsweise ist die erste Schaltung als Logikschaltung ausgebildet.

Vorzugsweise ist die erste Schaltung als nicht getaktete Logikschaltung ausgebildet.

Vorzugsweise weist die Logikschaltung ein Logikgatter auf.

Vorzugsweise sind ein erster Dateneingang des ersten Controllers und ein zweiter Dateneingang des zweiten Controllers über eine zweite Schaltung mit einem Datenausgang der ersten Schaltung, über den der Datenstrom ausgegeben wird, und einem Datenausgang eines dritten Controllers zur Kommunikationsverbindung, insbesondere über einen Bus, verbunden, wobei die zweite Schaltung das Einlesen der Teile des Datenstroms und ein Empfangen von Daten über den dritten Controller ermöglicht.

Ein erfindungsgemäßes Verfahren zum Erzeugen eines Datenstroms auf Basis redundanter Informationen nach Anspruch 11 umfasst ein Erzeugen erster Daten auf Basis erster Informationen durch einen ersten Controller, ein Erzeugen zweiter Daten auf Basis zweiter Informationen durch einen zweiten Controller, wobei die zweiten Informationen teilweise oder vollständig den ersten Informationen entsprechen, ein Aneinanderreihen eines ersten Teils der ersten Daten und eines zweiten Teils der zweiten Daten zur Erzeugung des Datenstroms, ein Einlesen zumindest des zweiten Teils der zweiten Daten des Datenstroms durch den ersten Controller, ein Einlesen zumindest des ersten Teils der ersten Daten des Datenstroms durch den zweiten Controller, ein Überprüfen der eingelesenen Daten auf Richtigkeit, wobei das Überprüfen ein Vergleichen, durch den zweiten Controller, des eingelesenen ersten Teils der ersten Daten mit einem ersten Teil der zweiten Daten und ein Vergleichen, durch den ersten Controller, des eingelesenen zweiten Teils der zweiten Daten mit einem zweiten Teil der ersten Daten umfasst, wenn das Vergleichen durch den ersten Controller eine Abweichung ergibt, ein Ausgeben von Daten, durch den ersten Controller, einzustellen und/oder ein Weiterleiten des Datenstroms zu blockieren, und, wenn das Vergleichen durch den zweiten Controller eine Abweichung ergibt, ein Ausgeben von Daten, durch den zweiten Controller, einzustellen und/oder das Weiterleiten des Datenstroms zu blockieren,

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, die in:
Fig. 1 ein System gemäß einem ersten Ausführungsbeispiel;
Fig. 2 einen zusammengesetzten Datenstrom;
Fig. 3 ein System gemäß einem zweiten Ausführungsbeispiel; und in
Fig. 4 ein Flussdiagramm eines Verfahrens zum Erzeugen eines Datenstroms auf Basis redundanter Informationen zeigen.

Dabei sind in den Zeichnungen gleiche und funktional ähnliche Elemente durch gleiche Bezugszeichen gekennzeichnet.

### DETAILLIERTE BESCHREIBUNG

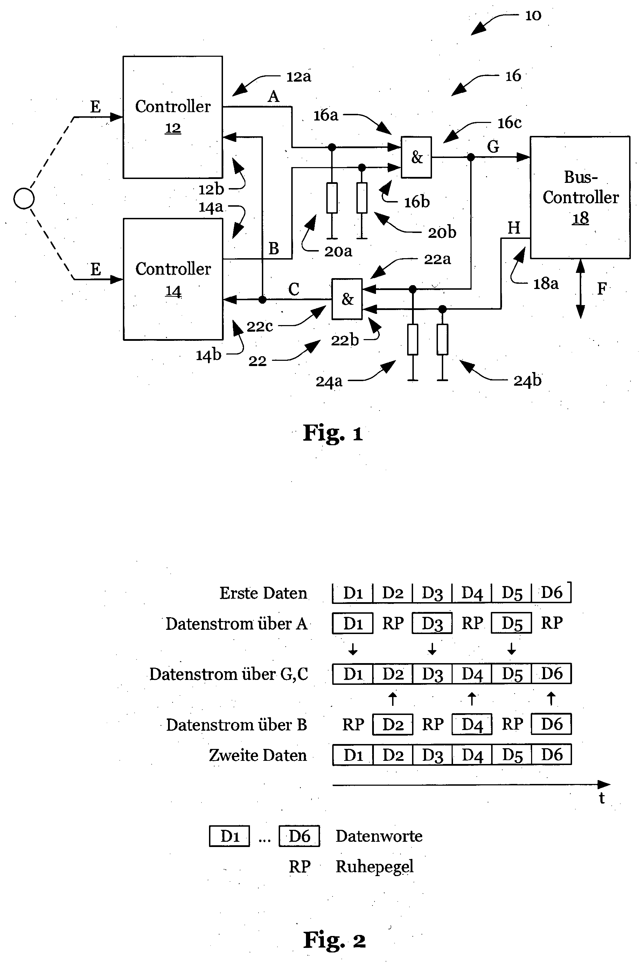

Fig. 1 zeigt ein System 10 mit einem ersten Controller 12 und einem zweiten Controller 14, die über eine erste Schaltung 16 mit einem Bus-Controller 18 verbunden sind. Die erste Schaltung 16 weist zwei Dateneingänge 16a, 16b auf, wobei ein erster Dateneingang 16a mittels der Datenleitung A (bspw. einer Leiterbahn oder einer Drahtleitung) an einem Datenausgang 12a des ersten Controllers 12 und ein zweiter Dateneingang 16b mittels der Datenleitung B (bspw. einer Leiterbahn oder einer Drahtleitung) an einem Datenausgang 14a des zweiten Controllers 14 angeschlossen ist. Die Datenleitungen A, B sind über Widerstände 20a, 20b ("Pulldown"-Widerstände) an Masse angeschlossen.

Die erste Schaltung 16 weist ferner einen Datenausgang 16c auf, an dem ein Ergebnis einer logischen Operation ausgegeben wird. Die logische Operation wird auf die, an den Dateneingängen 16a, 16b anliegenden Logikpegel angewendet, so dass der am Datenausgang 16c ausgegebene Logikpegel aus den an den Dateneingängen 16a, 16b anliegenden Logikpegel erzeugt wird. Wie in Fig. 1 gezeigt, ist am Datenausgang 16c der ersten Schaltung 16 mittels der Datenleitung G ein Bus-Controller 18 angeschlossen. Es versteht sich jedoch, dass anstatt des Bus-Controllers 18 auch ein anderer Kommunikationspartner am Datenausgang 16c der ersten Schaltung 16 angeschlossen sein kann.

Beide Controller 12, 14 werden im fehlerfreien Betrieb mit redundanten Informationen versorgt und sind eingerichtet, diese an den Bus-Controller 18 zu übertragen. Bspw. können beide Controller 12, 14, wie in Fig. 1 durch die gestrichelten Linien versinnbildlicht, mittels Datenleitungen E an einer gemeinsamen Informations- bzw. Datenquelle angeschlossen sein, bspw. einem oder mehreren Sensoren. Die Controller 12, 14 sind ferner eingerichtet, aus den Informationen/Daten erste und zweite Daten abzuleiten/zu berechnen, welche im fehlerfreien Betrieb übereinstimmen oder auf vorbestimmte Weise voneinander abweichen.

Fig. 2 illustriert hierzu einen Prozess zum Zusammensetzen eines Datenstroms aus Teilen übereinstimmender erster und zweiter Daten, die in den Controllern 12, 14 vorliegen. Dabei werden die Daten in den Controllern 12, 14 in sich entsprechende Teile (bspw. in Datenworte D1-D6 konstanter Größe) aufgeteilt. Wie in Fig. 2 illustriert, wird ein Datensegment (bzw. in Fig. 2 ein Datenwort) jeweils immer nur von einem der Controller 12, 14 an die erste Schaltung 16 übertragen. Durch die Schaltung 16 werden die Datensegmente wieder zu einem zusammenhängenden (lückenlosen) Datenstrom zusammenfügt, der im fehlerfreien Betrieb sowohl mit den ersten Daten als auch mit den zweiten Daten übereinstimmt. Überträgt ein Controller 12, 14 Daten, gibt der andere Controller 12, 14 im fehlerfreien Betrieb am Datenausgang 12a, 14a einen Ruhepegel aus. In der in Fig. 1 gezeigten Ausführungsform entspricht der Ruhepegel einem rezessiven Logikpegel, d. h. einer logischen 1, wobei es sich versteht, dass auch eine invertierte Logik mit einer ODER-Verknüpfung und "Pullup"-Widerständen eingesetzt werden kann.

Ein valider Datenstrom kann somit nur durch das Zusammenwirken beider Controller 12, 14 erzeugt werden. Dabei versteht es sich, dass der Datenstrom grundsätzlich aus einer beliebigen Anzahl an Segmenten (Teilen) gebildet sein kann, die von den Controllern 12, 14 im Wechsel bereitgestellt werden. Ferner versteht es sich, dass die Controller 12, 14 vorzugsweise synchronisiert sind. Die Synchronisation kann bspw. durch eine dedizierte Taktleitung oder durch das Rücklesen des Datenstroms erfolgen.

Zum Rücklesen des Datenstroms kann das System 10 eine zweite Schaltung 22 (oder eine Rückleseleitung) aufweisen, wobei ein erster Dateneingang 12b des ersten Controllers 12 und ein zweiter Dateneingang 14b des zweiten Controllers 14 über die zweite Schaltung 22 mit dem Datenausgang 16c der ersten Schaltung 16 verbunden sind. Wie in Fig. 1 gezeigt, kann die zweite Schaltung 22 einen Datenausgang 22c aufweisen, an dem ein Ergebnis einer logischen Operation ausgegeben wird, die auf die an den Dateneingängen 22a, 22b der zweiten Schaltung 22 anliegenden Logikpegel angewendet wird. Dabei ist ein erster Dateneingang 22a an der Datenleitung G bzw. dem Datenausgang 16c der ersten Schaltung 16 und ein zweiter Dateneingang 22b an einem Datenausgang des Bus-Controllers 18 angeschlossen (Datenleitung H).

Werden über die erste Schaltung 16 Daten an den Bus-Controller 18 übertragen, gibt der Bus-Controller 18 am Datenausgang 18a einen Ruhepegel aus, so dass der am Datenausgang 22c der zweiten Schaltung 22 ausgegebene Logikpegel dem am Dateneingang 22a anliegenden Logikpegel entspricht. Werden über die erste Schaltung 16 keine Daten an den Bus-Controller 18 übertragen, ermöglicht die zweite Schaltung 22 einen Empfang von Daten vom Bus-Controller 18.

Bspw. kann der Bus-Controller 18 über die Datenleitung F an einem Bus angeschlossen sein, über den der Bus-Controller 18 Daten an weitere Busteilnehmer übertragen bzw. Daten von weiteren Busteilnehmern empfangen kann. Somit ist über die Schaltungen 16, 22 eine bidirektionale Kommunikation möglich. Bei der bidirektionalen Kommunikation können bspw. Datentelegramme ausgetauscht werden, wobei ein, von beiden Controllern 12, 14 kooperativ erzeugtes Datentelegramm über die erste Schaltung 16 (und den Bus-Controller 18) an einen Kommunikationspartner versendet wird, der seinerseits mit einem Antworttelegramm antwortet, das über die zweite Schaltung 22 beiden Controllern 12, 14 zugestellt wird.

Werden über die erste Schaltung 16 Daten an den Bus-Controller 18 übertragen, lesen die Controller 12, 14 zumindest den Teil des zusammengesetzten Datenstroms ein, den der jeweils andere Controller 12, 14 erzeugt hat und überprüfen die eingelesenen Daten hinsichtlich Richtigkeit. Eine vorgeschaltete Kreuzkommunikation kann somit vermieden werden. Wird ein Fehler in den eingelesenen Daten festgestellt, kann der jeweilige Controller 12, 14 (d. h. der Controller 12, 14, der den Fehler festgestellt hat) die Ausgabe von Daten über den ersten Datenausgang 12a, 14a einstellen. Dadurch kann erzwungen werden, dass die am Datenausgang 16c der ersten Schaltung 16 ausgegebenen Daten (bzw. das am Datenausgang 16c der ersten Schaltung 16 ausgegebene Datenstromfragment) einem vorgegebenen Format nicht (mehr) entsprechen und ermöglicht so ein empfängerseitiges Aufdecken des Fehlers.

Bspw. kann der Bus-Controller 18 den empfangenen Datenstrom auf Übereinstimmung mit einem Datenrahmen- oder Datentelegramm-Format überprüfen oder ein oder mehrere im Datenstrom enthaltene Datentelegramme mittels redundanter Prüfwerte, welche über einen gesamten Datenrahmen oder ein gesamtes Datentelegramm berechnet wurden, validieren. Um Fehler möglichst früh erkennen zu können, können die Datenworte, welche die Prüfwerte enthalten, zuerst gesendet werden.

Alternativ oder zusätzlich kann der jeweilige Controller 12, 14 (d. h. der Controller 12, 14, der den Fehler festgestellt hat) die Ausgabe von Daten über den Datenausgang 16c der ersten Schaltung 16 blockieren, indem anstatt des Ruhepegels ein zum Ruhepegel invertierter, dominanter Logikpegel am Datenausgang 12a, 14a des jeweiligen Controllers 12, 14 ausgegeben wird, welcher sämtliche rezessive Logikpegel des anderen Controllers 12, 14 überschreibt, wodurch ebenfalls erzwungen werden kann, dass die am Datenausgang 16c der ersten Schaltung 16 ausgegebenen Daten (bzw. das am Datenausgang 16c der ersten Schaltung 16 ausgegebene Datenstromfragment) einem vorgegebenen Format nicht (mehr) entsprechen (und der Fehler empfängerseitig aufgedeckt werden kann).

Eine Blockade der Ausgabe von Daten über den Datenausgang 16c der ersten Schaltung 16 kann zudem auch dann erfolgen, wenn ein Controller 12, 14 (bspw. auf Grund eines externen oder internen Fehlers) in einen sicheren Zustand wechselt, indem die Widerstände 24a, 24b so geschaltet sind, dass beim Ausfall eines Controllers 12, 14 ein dominanter Signalpegel erzeugt wird, der die Kommunikation des verbleibenden Controllers 12, 14 blockiert. Somit blockiert die Blockade der Übertragung von Daten über die erste Schaltung 16 auch die Übertragung von Daten über die zweite Schaltung 22, da in diesem Zustand ein dominanter Logikpegel am ersten Dateneingang 22a anliegt. Wird hingegen im fehlerfreien Betrieb bspw. auf eine Antwort eines Kommunikationspartners gewartet, kann die Übertragung yon Daten über die zweite Schaltung 22 durch Anlegen eines rezessiven Logikpegels an den ersten Dateneingang 22a ermöglicht werden.

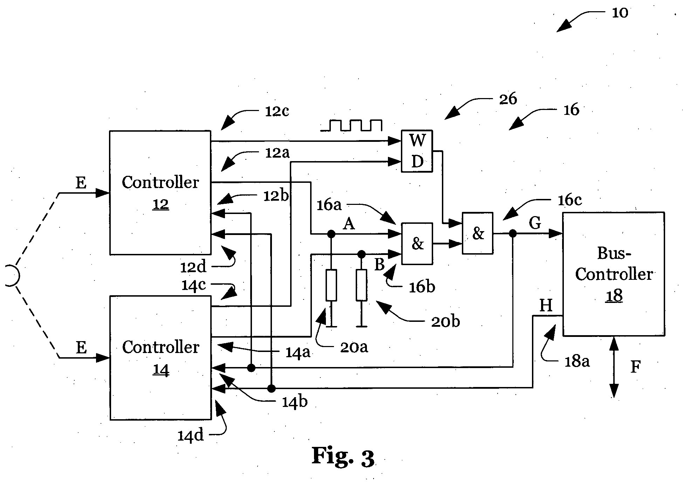

Fig. 3 zeigt eine modifizierte Ausgestaltung des Systems 10. Dieses unterscheidet sich von dem in Fig. 1 gezeigten System 10 dadurch, dass anstatt der zweiten Schaltung 22 zwei separate Y-Datenleitungen vorgesehen sind. Eine Y-Datenleitung verbindet den Datenausgang 16c der ersten Schaltung 16 mit den Rückleseeingängen der Controller 12, 14 und die zweite Y-Datenleitung verbindet den Datenausgang des Bus-Controllers 18 mit Dateneingängen 12d, 14d der Controller 12, 14 zur Übertragung von Daten vom Bus-Controller 18 zu den Controllern 12, 14. Dies ermöglicht ein voneinander unabhängiges (und daher zeitgleiches) Ausgeben und Einlesen von Daten durch die Controller 12, 14.

Ferner unterscheidet sich das in Fig. 3 gezeigte System 10 von dem in Fig. 1 gezeigten System 10 dadurch, dass die erste Schaltung 16 um einen Funktionswächter 26 ("Watchdog") erweitert ist. Der Funktionswächter 26 ist an Signalausgängen 12c, 14c der Controller 12, 14 angeschlossen, die es ermöglichen den Funktionswächter 26 bei fehlerfreien Betrieb des Systems 10 mit einem Signal anzusteuern, welches bewirkt, dass der Funktionswächter 26 eine Übertragung der Daten von den Controllern 12, 14 zum Bus-Controller 18 zulässt. Wenn ein Controller 12, 14 (bspw. auf Grund eines externen oder internen Fehlers) ausfällt oder in einen sicheren Zustand wechselt und daher das Signal zur Ansteuerung des Funktionswächters 26 nicht (mehr) ausgibt, blockiert der Funktionswächter 26 eine Übertragung von Daten an den Bus-Controller 18.

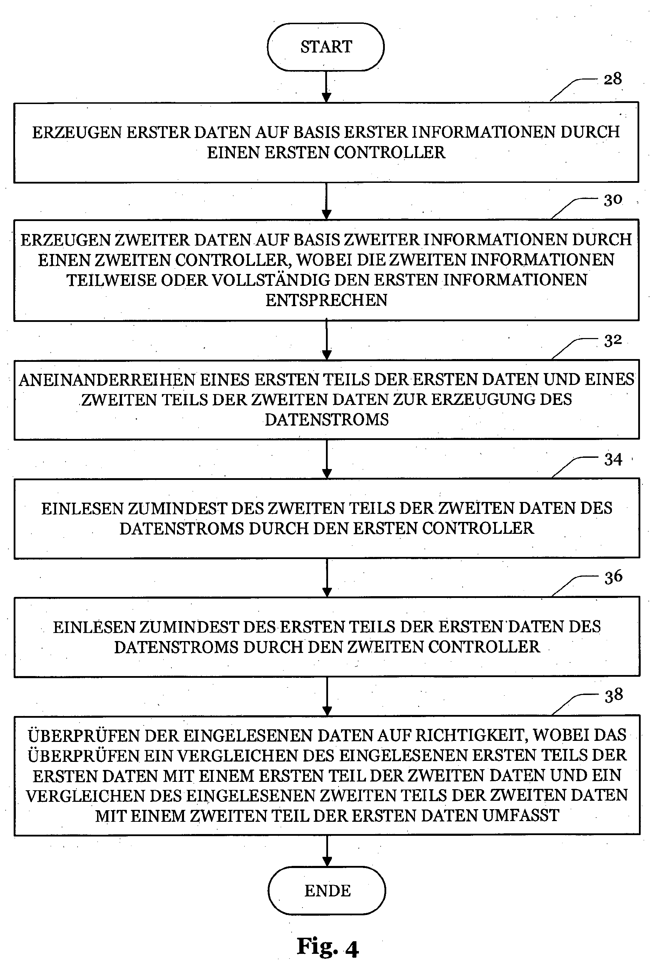

Fig. 4 zeigt ein Flussdiagramm eines Verfahrens zum Erzeugen eines Datenstroms auf Basis redundanter Informationen, welches in den in Fig. 1 und Fig. 3 gezeigten Systemen 10 durchgeführt werden kann. Das Verfahren beginnt mit den Schritten 28, 30 des Erzeugens erster Daten auf Basis erster Informationen durch den ersten Controller 12 und des Erzeugens 30 zweiter Daten auf Basis zweiter Informationen durch den zweiten Controller 14, wobei die zweiten Informationen teilweise oder vollständig den ersten Informationen entsprechen. In Schritt 32 werden ein erster Teil der ersten Daten und ein zweiter Teil der zweiten Daten zur Erzeugung des Datenstroms zusammengefügt.

Nach den Schritten 34, 36 des Einlesens zumindest des zweiten Teils der zweiten Daten des Datenstroms durch den ersten Controller 12 und des Einlesens zumindest des ersten Teils der ersten Daten des Datenstroms durch den zweiten Controller 14, werden in Schritt 38 die eingelesenen Daten auf Richtigkeit überprüft, wobei das Überprüfen ein Vergleichen des eingelesenen ersten Teils der ersten Daten mit einem ersten Teil der zweiten Daten und ein Vergleichen des eingelesenen zweiten Teils der zweiten Daten mit einem zweiten Teil der ersten Daten umfasst.

Werden in dem Vergleich Unterschiede festgestellt, die auf einen Fehler beim Erzeugen oder Übertragen der Daten hinweisen, kann die Übertragung weiterer Daten über die erste Schaltung 16 blockiert werden, indem einer der Controller 12, 14 die Übertragung von Daten des anderen Controllers 12, 14 mittels Ausgabe eines dominanten Logikpegels unterbindet bzw. die Übertragung eigener Daten einstellt.

Zudem kann jeder Controller 12, 14 eingerichtet sein, seine ausgegebenen Daten rückzulesen und mit den auszugebenden Daten zu vergleichen. Dadurch kann festgestellt werden, ob der jeweils andere Controller 12, 14 den Ruhepegel korrekt ausgibt bzw. sich an das abwechselnde Senden hält und die Kommunikation des anderen Controllers 12,14 nicht stört.

### BEZUGSZEICHENLISTE

- 10: System
- 12: Controller
- 12a: Datenausgang
- 12b: Dateneingang
- 12c: Signalausgang
- 12d: Dateneingang
- 14: Controller
- 14a: Datenausgang
- 14b: Dateneingang
- 14c: Signalausgang
- 14d: Dateneingang
- 16: Schaltung
- 16a: Eingang
- 16b: Eingang
- 16c: Ausgang
- 18: Bus-Controller
- 18a: Datenausgang
- 20a: Widerstand
- 20b: Widerstand
- 22: Schaltung
- 24a: Widerstand
- 24b: Widerstand
- 26: Funktionswächter
- 28-38: Prozessschritte

## Patentansprüche

1. System (10) zum Erzeugen eines Datenstroms auf Basis redundanter Informationen, umfassend:
einen ersten Controller (12), welcher einen ersten Datenausgang (12a) aufweist, wobei der erste Controller (12) eingerichtet ist, erste Daten zu erzeugen und einen ersten Teil erster Daten über den ersten Datenausgang (12a) auszugeben;
einen zweiten Controller (14), welcher einen zweiten Datenausgang (14a)aufweist, wobei der zweite Controller (14) eingerichtet ist, zweite Daten zu erzeugen und einen zweiten Teil zweiter Daten über den zweiten Datenausgang (14a) auszugeben, wobei die zweiten Daten im fehlerfreien Betrieb mit den ersten Daten übereinstimmen oder auf vorbestimmte Weise davon abweichen; ; und
eine erste Schaltung (16), welche mit dem ersten Datenausgang (12a) und dem zweiten Datenausgang (14a) verbunden ist, wobei die erste Schaltung (16) eingerichtet ist, die über den ersten und den zweiten Datenausgang (12a, 14a) ausgegeben Daten zu einem Datenstrom zusammenzusetzen; wobei
der erste Controller (12) eingerichtet ist, zumindest den zweiten Teil zweiter Daten des zusammengesetzten Datenstroms einzulesen;
der zweite Controller (14) eingerichtet ist, zumindest den ersten Teil erster Daten des zusammengesetzten Datenstroms einzulesen;
**dadurch gekennzeichnet, dass**
der erste Controller (12) eingerichtet ist, den eingelesenen zweiten Teil zweiter Daten mit einem zweiten Teil der ersten Daten zu vergleichen und, wenn der Vergleich eine Abweichung ergibt, eine Ausgabe von Daten über den ersten Datenausgang (12a) einzustellen und/oder die Weiterleitung des Datenstroms zu blockieren; und
der zweite Controller (14) eingerichtet ist, den eingelesenen ersten Teil erster Daten mit einem ersten Teil der zweiten Daten zu vergleichen und, wenn der Vergleich eine Abweichung ergibt, eine Ausgabe von Daten über den zweiten Datenausgang (14a) einzustellen und/oder die Weiterleitung des Datenstroms zu blockieren.

2. System (10) nach Anspruch 1, wobei die ersten Daten und die zweiten Daten die redundanten Informationen aufweisen.

3. System (10) nach Anspruch 1 oder 2, wobei, wenn die Vergleiche keine Abweichungen ergeben, der Datenstrom den zweiten Teil erster Daten und den ersten Teil zweiter Daten aufweist.

4. System (10) nach Anspruch 3, wobei, wenn die Vergleiche keine Abweichungen ergeben, die ersten Daten mit den zweiten Daten übereinstimmen,

5. System (10) nach einem der Ansprüche 1 bis 4, wobei die Controller (12,14) derart synchronisiert sind, dass der erste Teil erster Daten und der zweite Teil zweiter Daten nicht gleichzeitig ausgegeben werden.

6. System (10) nach einem der Ansprüche 1 bis 5, wobei der zweite Controller (14) eingerichtet ist, sich mittels Einlesens des Datenstroms mit dem ersten Controller zu synchronisieren und den zweiten Teil zweiter Daten über den zweiten Datenausgang (14a) auszugeben, nachdem der erste Controller (12) den ersten Teil erster Daten über den ersten Datenausgang (12a) ausgegeben hat.

7. System (10) nach einem der Ansprüche 1 bis-6, wobei die erste Schaltung (16) als Logikschaltung ausgebildet ist.

8. System (10) nach einem der Ansprüche 1 bis 7, wobei die erste Schaltung (16) als nicht getaktete Logikschaltung ausgebildet ist.

9. System (10) nach Anspruch 7 oder 8, .wobei die Logikschaltung ein Logikgatter aufweist.

10. System (10) nach einem der Ansprüche 1 bis 9, wobei ein erster Dateneingang (12b) des ersten Controllers (12) und ein zweiter Dateneingang (14b) des zweiten Controllers (14) über eine zweite Schaltung (22) mit einem Datenausgang (16c) der ersten Schaltung (16), über den der Datenstrom ausgegeben wird, und einem Datenausgang eines dritten Controllers (18) zur Kommunikationsverbindung, insbesondere über einen Bus, verbunden sind, wobei die zweite Schaltung (22) das Einlesen der Teile des Datenstroms und ein Empfangen von Daten über den dritten Controller (18) ermöglicht.

11. Verfahren zum Erzeugen eines Datenstroms auf Basis redundanter Informationen, umfassend:
Erzeugen (28) erster Daten auf Basis erster Informationen durch einen ersten Controller;
Erzeugen (30) zweiter Daten auf Basis zweiter Informationen durch einen zweiten Controller, wobei die zweiten Informationen teilweise oder vollständig den ersten Informationen entsprechen;
Aneinanderreihen (32) eines ersten Teils der ersten Daten und eines zweiten Teils der zweiten Daten zur Erzeugung des Datenstroms;
Einlesen (34) zumindest des zweiten Teils der zweiten Daten des Datenstroms durch den ersten Controller;
Einlesen (36) zumindest des ersten Teils der ersten Daten des Datenstroms durch den zweiten Controller;
**gekennzeichnet durch**
ein Überprüfen (38) der eingelesenen Daten auf Richtigkeit, wobei das Überprüfen ein Vergleichen, durch den zweiten Controller, des eingelesenen ersten Teils der ersten Daten mit einem ersten Teil der zweiten Daten und ein Vergleichen, durch den ersten Controller, des eingelesenen zweiten Teils der zweiten Daten mit einem zweiten Teil der ersten Daten umfasst; und
wenn das Vergleichen durch den ersten Controller eine Abweichung ergibt, ein Ausgeben von Daten, durch den ersten Controller, einzustellen und/oder ein Weiterleiten des Datenstroms zu blockieren; und
wenn das Vergleichen durch den zweiten Controller eine Abweichung ergibt, ein Ausgeben von Daten, durch den zweiten Controller, einzustellen und/oder das Weiterleiten des Datenstroms zu blockieren.

## Claims

1. System (10) for producing a data stream on the basis of redundant information, comprising:
a first controller (12) having a first data output (12a), wherein the first controller (12) is designed to produce first data and output a first part of first data via the first data output (12a);
a second controller (14) having a second data output (14a), wherein the second controller (14) is designed to produce second data and output a second part of second data via the second data output (14a), wherein, during error-free operation, the second data match the first data or deviate therefrom in a predetermined manner;
and
a first circuit (16) connected with the first data output (12a) and the second data output (14a), wherein the first circuit (16) is designed to combine the data that are output via the first and the second data output (12a, 14a) to form a data stream; wherein
the first controller (12) is designed to read in at least the second part of second data from the combined data stream;
the second controller (14) is designed to read in at least the first part of first data from the combined data stream;
**characterised in that**
the first controller (12) is designed to compare the read-in second part of second data with a second part of the first data and, if the comparison indicates a deviation, to stop outputting data via the first data output (12a) and/or to block the forwarding of the data stream; and
the second controller (14) is designed to compare the read-in first part of first data with a first part of the second data and, if the comparison indicates a deviation, to stop outputting data via the second data output (14a) and/or to block the forwarding of the data stream.

2. System (10) according to claim 1, wherein the first data and the second data have the redundant information.

3. System (10) according to claim 1 or 2, wherein, if the comparisons do not indicate any deviations, the data stream has the second part of first data and the first part of second data.

4. System (10) according to claim 3, wherein, if the comparisons do not indicate any deviations, the first data match the second data,

5. System (10) according to any of claims 1 to 4, wherein the controllers (12, 14) are synchronised such that the first part of first data and the second part of second data are not output simultaneously.

6. System (10) according to any of claims 1 to 5, wherein the second controller (14) is designed to synchronise with the first controller by reading in the data stream and to output the second part of second data via the second data output (14a) after the first controller (12) has output the first part of first data via the first data output (12a).

7. System (10) according to any of claims 1 to-6, wherein the first circuit (16) is configured as a logic circuit.

8. System (10) according to any of claims 1 to 7, wherein the first circuit (16) is configured as a non-clocked logic circuit.

9. System (10) according to claim 7 or 8, .wherein the logic circuit has a logic gate.

10. System (10) according to any of claims 1 to 9, wherein a first data input (12b) of the first controller (12) and a second data input (14b) of the second controller (14) are connected, in particular via a bus, to establish a communication link, via a second circuit (22), with a data output (16c) of the first circuit (16) via which the data stream is output, and with a data output of a third controller (18), wherein the second circuit (22) enables the parts of the data stream to be read in and data to be received via the third controller (18).

11. Method for producing a data stream on the basis of redundant information, comprising:
producing (28), by means of a first controller, first data on the basis of first information;
producing (30), by means of a second controller, second data on the basis of second information, wherein the second information partially or entirely matches the first information;
juxtaposing (32) a first part of the first data and a second part of the second data to produce the data stream;
reading in (34) at least the second part of the second data of the data stream by the first controller;
reading in (36) at least the first part of the first data of the data stream by the second controller;
**characterised by**
checking (38) the read-in data for correctness, wherein the checking comprises comparing, by means of the second controller, the read-in first part of the first data with a first part of the second data and comparing, by means of the first controller, the read-in second part of the second data with a second part of the first data; and
if the comparison by the first controller indicates a deviation, stopping output of data by the first controller and/or blocking forwarding of the data stream; and
if the comparison by the second controller indicates a deviation, stopping output of data by the second controller and/or blocking the forwarding of the data stream.

## Revendications

1. Système (10) pour la génération d'un flux de données sur la base d'informations redondantes, comprenant :
un premier contrôleur (12) qui présente une première sortie de données (12a), dans lequel le premier contrôleur (12) est conçu pour générer des premières données et émettre une première partie de premières données via la première sortie de données(12a) ;
un deuxième contrôleur (14) qui présente une seconde sortie de données (14a), dans lequel le deuxième contrôleur (14) est conçu pour générer des secondes données et émettre une seconde partie de secondes données via la seconde sortie de données (14a), dans lequel les secondes données coïncident avec les premières données dans un fonctionnement sans défaut ou diffèrent de celles-ci d'une manière prédéterminée ;
et
un premier circuit (16) qui est relié à la première sortie de données (12a) et à la seconde sortie de données (14a), dans lequel le premier circuit (16) est conçu pour regrouper les données émises via la première et la seconde sortie de données (12a, 14a) en un flux de données ; dans lequel
le premier contrôleur (12) est conçu pour lire au moins la seconde partie de secondes données du flux de données regroupé ;
le deuxième contrôleur (14) est conçu pour lire au moins la première partie de premières données du flux de données regroupé ;
**caractérisé en ce que**
le premier contrôleur (12) est conçu pour comparer la seconde partie lue de secondes données avec une seconde partie des premières données et, lorsque la comparaison donne une différence, pour régler une émission de données via la première sortie de données (12a) et/ou pour bloquer la transmission du flux de données ; et
le deuxième contrôleur (14) est conçu pour comparer la première partie lue de premières données avec une première partie des secondes données et, lorsque la comparaison donne une différence, pour régler une émission de données via la seconde sortie de données (14a) et/ou pour bloquer la transmission du flux de données.

2. Système (10) selon la revendication 1, dans lequel les premières données et les secondes données présentent les informations redondantes.

3. Système (10) selon la revendication 1 ou 2, dans lequel, lorsque les comparaisons ne donnent aucune différence, le flux de données présente la seconde partie de premières données et la première partie de secondes données.

4. Système (10) selon la revendication 3, dans lequel lorsque les comparaisons ne donnent pas de différences, les premières données coïncident avec les secondes données.

5. Système (10) selon l'une quelconque des revendications 1 à 4, dans lequel les contrôleurs (12, 14) sont synchronisés de telle sorte que la première partie de premières données et la seconde partie de secondes données ne sont pas émises simultanément.

6. Système (10) selon l'une quelconque des revendications 1 à 5, dans lequel le deuxième contrôleur (14) est conçu pour se synchroniser avec le premier contrôleur au moyen de la lecture du flux de données et émettre la seconde partie de secondes données via la seconde sortie de données (14a) après que le premier contrôleur (12) a émis la première partie de premières données via la première sortie de données (12a).

7. Système (10) selon l'une quelconque des revendications 1 à-6, dans lequel le premier circuit (16) est réalisé en tant que circuit logique.

8. Système (10) selon l'une quelconque des revendications 1 à 7, dans lequel le premier circuit (16) est réalisé en tant que circuit logique non cadencé.

9. Système (10) selon la revendication 7 ou 8, .dans lequel le circuit logique présente une porte logique.

10. Système (10) selon l'une quelconque des revendications 1 à 9, dans lequel une première entrée de données (12b) du premier contrôleur (12) et une seconde entrée de données (14b) du deuxième contrôleur (14) sont reliées via un deuxième circuit (22) à une sortie de données (16c) du premier circuit (16) via laquelle le flux de données est émis, et à une sortie de données d'un troisième contrôleur (18) pour une liaison de communication, en particulier via un bus, dans lequel le second circuit (22) rend possible la lecture des parties du flux de données et une réception de données via le troisième contrôleur (18).

11. Procédé pour la génération d'un flux de données sur la base d'informations redondantes, comprenant :
la génération (28) de premières données sur la base de premières informations par le biais d'un premier contrôleur ;
la génération (30) de secondes données sur la base de secondes informations par le biais d'un deuxième contrôleur, dans lequel les secondes informations correspondent partiellement ou totalement aux premières informations ;
la juxtaposition (32) d'une première partie des premières données et d'une seconde partie des secondes données pour la génération du flux de données ;
la lecture (34) d'au moins la seconde partie des secondes données du flux de données par le biais du premier contrôleur ;
la lecture (36) d'au moins la première partie des premières données du flux de données par le biais du deuxième contrôleur ;
**caractérisé par**
une vérification (38) de la pertinence des données lues, dans lequel la vérification comprend une comparaison, par le biais du deuxième contrôleur, de la première partie lue des premières données avec une première partie des secondes données et une comparaison, par le biais du premier contrôleur, de la seconde partie lue des secondes donnés avec une seconde partie des premières données ; et
lorsque la comparaison par le biais du premier contrôleur donne une différence, pour bloquer une émission de données, par le biais du premier contrôleur, et/ou une transmission du flux de données ; et
lorsque la comparaison par le biais du deuxième contrôleur donne une différence, pour régler une émission de données, par le biais du deuxième contrôleur, et/ou pour bloquer la transmission du flux de données.
